# EUROPEAN PATENT SPECIFICATION

(11) **EP 0 827 156 B1**
(45) Date of publication and mention of the grant of the patent: **26.02.2003**
(21) Application number: 97306413.2
(22) Date of filing: 22.08.1997
(51) Int. Cl.: G11C 19/12, G11C 19/28

(54) **Shift register using negative resistance devices**
Schieberegister mit negativen Widerstandselementen
Registre à décalage utilisant des éléments à résistance négative

(30) Priority: 26.08.1996 US 24568 P
(43) Date of publication of application: 04.03.1998
(73) Proprietor: TEXAS INSTRUMENTS INCORPORATED, Dallas Texas 75265 (US)
(72) Inventor: Tang, Hao, Silver Spring, Maryland 20910 (US); Broekaert, Tom P., Dallas, Texas 75243 (US)
(74) Representative: Pearson, James Ginn

(56) References cited:
- US-A- 3 121 176
- US-A- 4 902 912
- US-A- 5 444 751
- PATENT ABSTRACTS OF JAPAN vol. 013, no. 080 (P-832), 23 February 1989 & JP 63 261600 A (FUJITSU LTD), 28 October 1988

## Description

### FIELD OF THE INVENTION

The present invention relates generally to electronic circuits and, more specifically, to very high speed digital shift registers using negative resistance devices such as resonant tunneling diodes and the like.

### BACKGROUND OF THE INVENTION

Extensive prior art exists in the application of two terminal negative resistance devices developed after the publication by Leo Esaki of "New Phenomenon in Narrow Germanium p=n Junctions", Phys, Rev., Vol. 109, p.603, January 15 1958. However, as the title of the article indicates, a resonant tunnel diode (RTD) with its plurality of thin semiconducting layers having different physical properties is markedly different from Esaki's single p-n junction. Although the shape of the plot of device current vs. voltage is superficially similar, the scale is grossly different. In addition, the manufacturing technology available to achieve massive arrays of virtually identical RTDs is not available for Esaki tunnel diodes. In its simplest form, an RTD consists of a sequence of five semiconductor layers. The outer two layers are the contact layers into which electrons enter and exit the semiconductor layer sequence. The interior three dissimilar semiconductor layers differ in their energy band gaps in the sequence of wide/narrow/wide band gap with layer thicknesses comparable to the electron Bloch wavelength (typically less than 10 nm). The electron path through these layers consists of two energy barriers separated by a narrow region referred to as a quantum well.

Classically, an electron with energy, called Fermi energy, approaching the first energy barrier with an energy below the barrier energy is reflected. As the physical dimensions of the barrier decrease toward the wavelength of the particle, there is an increasing probability that the particle will be transmitted instead of reflected. Thus, under certain conditions, an electron can pass through the barrier with energy below the barrier potential. This phenomenon is called tunneling.

If the quantum well width is selected to be approximately equal to some half integer multiple of the electron wavelength, a standing wave can be built up by constructive interference analogous to the standing waves in a transmission line or microwave cavity. Electrons at these wavelengths couple into and out of the quantum well more readily than others.

Since the electron's energy can be controlled by adjusting the voltage across the structure, the current flow through the double barrier is quite sensitive to this applied voltage. For certain applied voltages, the electrons readily pass through the double barrier and for other applied voltages are almost totally reflected. The electron is said to be in resonance when the incoming electron energy matches the resonant transmission energy of the quantum-well structure.

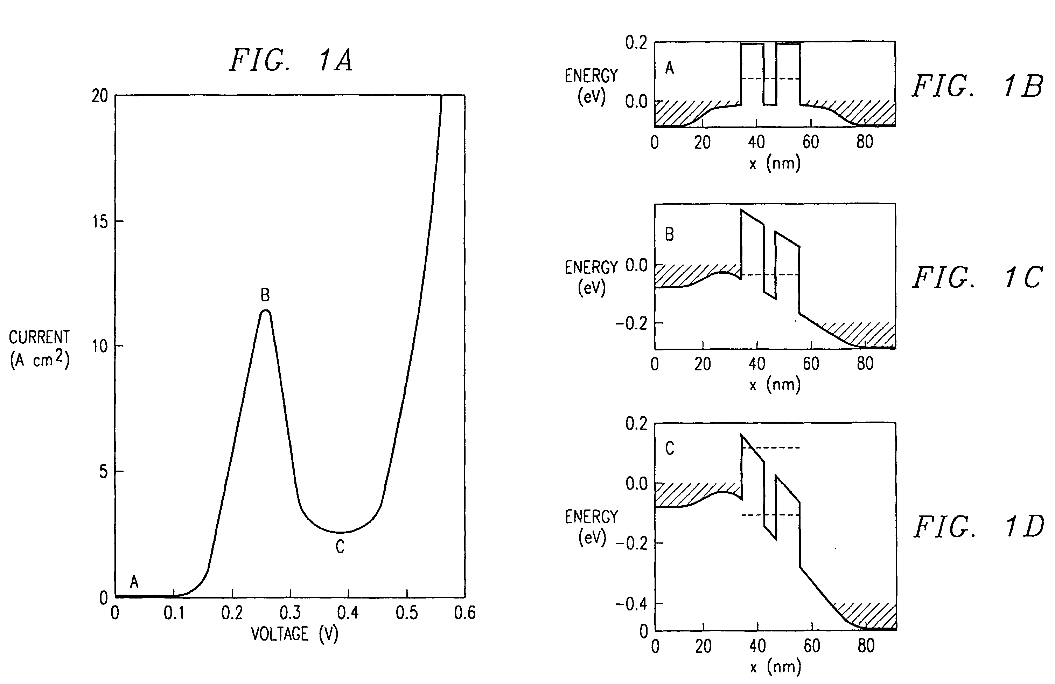

The prior art shown in FIG. 1, "Resonant Tunneling Transistors", TI Technical Journal, p.30,Jul-Aug 1989, shows the current vs. voltage (I-V) characteristic and the corresponding conduction band profile of an RTD. The interesting feature of this characteristic is that between points B and C where an increase in applied voltage actually causes a decrease in device current. This region of "negative differential resistance" is highly unstable. The ratio of the voltage at B to C is referred to as the peak-to-valley ratio and is quite important in determining the noise margins of RTDs applied to digital devices. The previously mentioned scale differences in these characteristics between RTDs and older Esaki single junction tunnel diodes is quite dramatic. RTDs can be fabricated whose peak currents are reproducible from device to device and may range from 100 picoamps to greater than 100 milliamps while maintaining useable peak to valley ratios. Esaki diodes operate in the tens of milliamps regime. This allows RTDs to be tailored to the application. In memory devices where power and size are the prime concerns, very low current devices are the choice. In high speed logic where capacitive loads may occur, high current devices are desired.

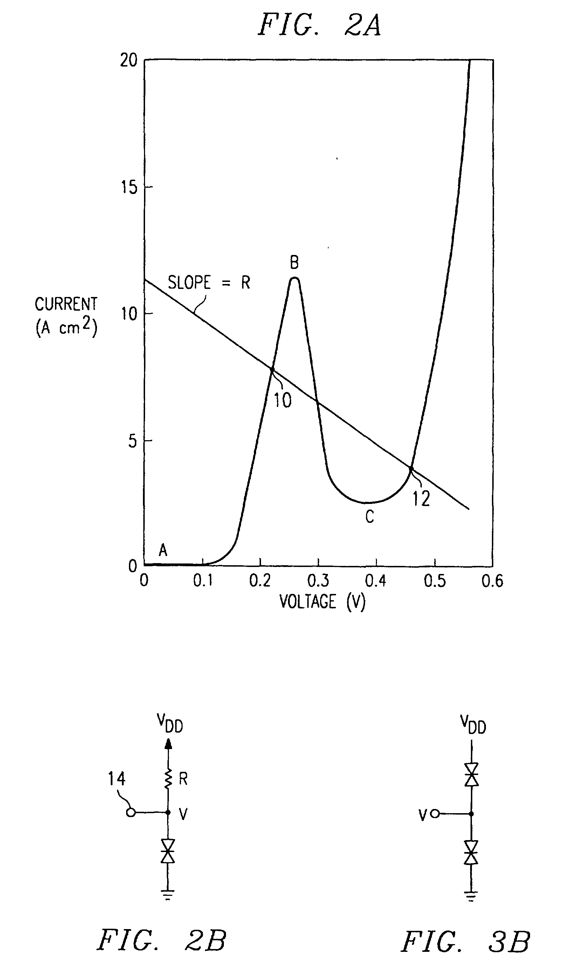

As has been done in prior art, adding a resistor in series with the diode as illustrated in FIG.2 achieves a bistable circuit whose static resting point is either 10 or 12. By applying a control voltage at 14, the device can be forced to either 10 or 12 making it into a reset table binary latch. This structure is disadvantageous because of (1) power dissipation, (2) manufacturability and (3) operating speed among other problems. US 3,121,176 illustrates a shift register comprising a plurality of cascaded stages. Each stage includes a bistable circuit for static storage comprising a negative resistance diode connected in series with a register and a monostable circuit for dynamic storage and connection to the next stage. The bistable portion includes a PNP transistor connected by its base to the junction between the diode and register and via its collector to the monostable circuit.

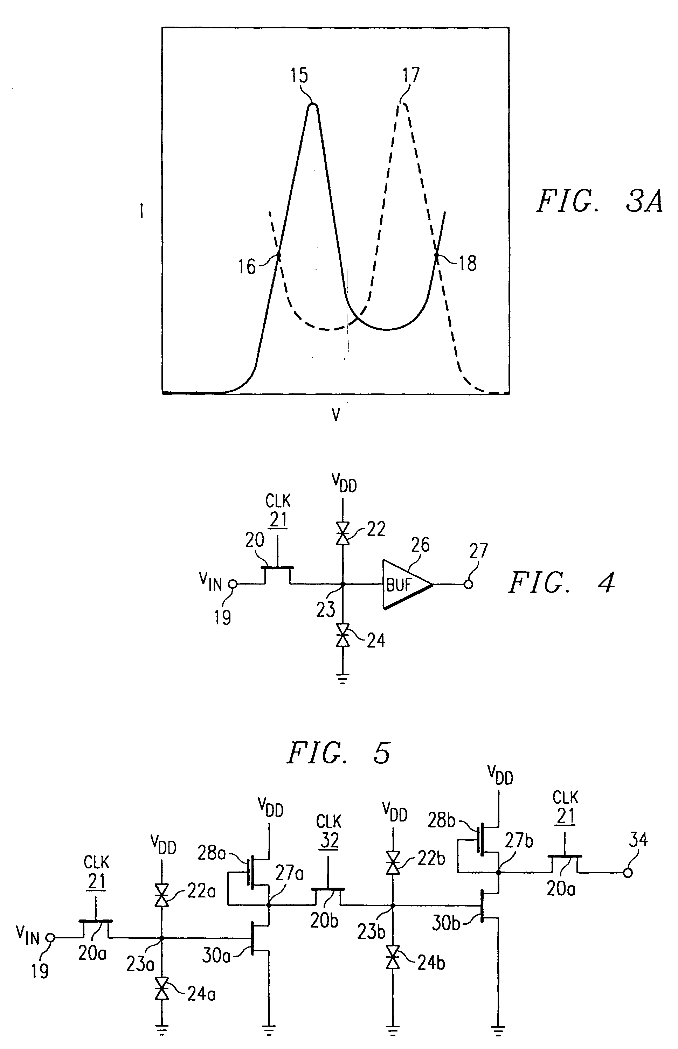

A more suitable structure, as further explained below with reference to the present invention, is to series connect two RTDs in a manner similar to that proposed by Goto, et al in IRE Trans. On Electronic Computers, March 1960, p.24 using conventional Esaki tunnel diodes and studied extensively by RCA, RCA Review, vol XXXIII, June 1962, p. 152 and Dec. 1962, p. 489. The series connection of two RTDs and their bistable operating points 16 and 18 is illustrated in FIG.3. It is this configuration which is exploited by this invention.

Modern digital systems require the acquisition, transfer and storage of digital bit streams at gigahertz clock frequencies. Most systems in this frequency range use a continuous or synchronous clock with dynamic shift registers. A dynamic shift register stores the binary ones and zeroes in capacitors, normally the parasitic capacitances of the circuit interconnects. However, in many systems the data stream is asynchronous, i.e. stops and starts. However, in a dynamic system, the data may be lost due to capacitor leakage if the clock is stopped for too long a period. The faster the clock the smaller the capacitor and the sooner the data is lost if the clock stops. A static shift register can be used to overcome this difficulty. However, static circuits require more components and hence device and interconnect delays. Many times these circuits also dissipate considerably more power than their dynamic counterparts. As seen in FIG.3 both stable points 16 and 18 are at low current.

### SUMMARY OF THE INVENTION

It is a primary objective of the present invention to overcome the above mentioned difficulties by providing means to interconnect shift registers for the transmission and storage of ultra high speed (> 1 GHz) bit streams using an asynchronous clock while maintaining small size.

Thus according to the present invention there is provided a storage cell as set forth in claim 1. Further features which may be incorporated into the storage cell of the invention are set forth in claims 2 to 4.

According to a preferred embodiment, the present invention includes a cascaded pair of RTDs to achieve a bistable operating state. The provision of the buffer amplifier enables one bistable pair to drive a following pair, the buffer amplifier providing isolation and gain between the two pairs of RTDs.

Some alternate means for achieving the buffer isolation between shift register stages while still retaining high speed and small size are shown, by way of example, in the accompanying drawings.

After the receipt of data transmitted at a rate above a gigahertz, it is often desired to store this data and then transmit the same data at a slower rate so that the data may be stored and processed by slower more conventional digital systems. This can be conveniently implemented by this ultra high speed static shift register invention by clocking the shift register at a very high rate during data reception, and then a much slower clock rate. This slower clock frequency may be preceded by a short delay in order to be synchronous with the downstream clock frequency if desired. The data in the shift register may then be clocked out at a lower rate. A source follower is provided to drive downstream digital processing circuitry where capacitive loading may otherwise cause problems.

The invention also further provides a static shift register as set forth in claim 5. Further features which may be incorporated into the static shift register of the invention are set forth in claims 6 to 10.

### BRIEF DESCRIPTIONS OF THE DRAWINGS

The foregoing features of the present invention may be understood more fully from the following detailed description, read in conjunction with the accompanying drawings which show examples of prior art devices and illustrate, by way of example, an embodiment of the present invention and in which:
FIG. 1 illustrates a graph of the current through an RTD versus voltage and the corresponding energy level diagrams;
FIG. 2 illustrates the bistable operating points of an RTD with a load resistor according to a prior art device;
FIG. 3 illustrates the resulting bistable operating points of two RTDs connected in series;
FIG. 4 illustrates a generic single shift register cell formed from two series connected RTDs to form a static latch which may be driven from a previous input and provides a buffer amplifier to drive a following stage of similar configuration;
FIG. 5 illustrates a few stages of a static shift register where the buffer amplification stage consists of a cascaded depletion field effect transistor (FET) and enhancement mode FET;
FIG. 6 illustrates a higher speed connection of FIG.5 by replacing the depletion load FET with an RTD having different characteristics from the RTDs used for the bistable latch configuration; and
FIG.7 illustrates a buffer amplifier of the source- follower type to provide increased speed and drive capability for the output stages of the shift register.

### DESCRIPTION OF PREFERRED EMBODIMENTS

Referring initially to FIG. 4, a generic shift register stage, there is shown a series connection of RTDs 22 and 24 whose I-V characteristics are matched and which are supplied with power from V_{dd} to ground. This is the bistable configuration previously described in reference to FIG. 3 which showed peak currents at 15 and 17. For the purpose of discussion, a low voltage state at connection 23 will be considered a binary O and a high voltage state at connection 23 as a binary 1. When clock 21 is applied to switching transistor 20, the voltage 19 is tied directly to the junction 23 of the series connected RTDs 22 and 24. If the voltage 19 is lower than peak 15, 23 is forced to the stable point 16, the binary 0 state. Conversely, when the voltage 19 is higher than peak 17, 23 is forced to the stable point 18, the binary 1 state. The clock 21 now turns "OFF" switching transistor 21 and the forced state at 23 remains. To facilitate the driving of the next stage of the shift register buffer amplifier 26 is connected between 23 and the output node 27. This buffer amplifier provides isolation between 23 and the next stage as well as providing gain to insure that the next stage receives adequate power to set that stage at a binary 1 or 0.

A more complete circuit of a segment of an ultra high speed shift register is shown in FIG.5 in which the buffer amplifier consists of an enhancement FET 30 to supply gain and a depletion load device 28. Although the devices with like number are duplicates for ease of processing large scale integrated circuits, suffix letters "a" and "b" have been added to distinguish the first stage of the shift register from the second stage to simplify description. Assume that the unput voltage at 19 is at binary 1, high voltage. Clock 21 turns "ON" switch transistor 20a. The corresponding switch transistor 20b in the second stage of the shift register is driven by 32 which is the complement of 21 which turns "OFF" transistor 20b. As discussed previously, 19 sets connection 23a to the binary 1 state. Connection 23a is common with the gate of 30a. The voltage inversion of the buffer causes 27a to be at a low voltage although switch 20b is still "OFF" and therefore no effect is seen by 23b as yet. On the complementary phase of the clock, 20a is turned "OFF" and 20b is turned "ON". This sets the bistable latch composed of 22b and 24b to the binary 0 state, i.e. connection 23b is at a low voltage. At this point if we terminate clock signals 21 and 32, the following binary conditions will remain in the static, stable condition - (1) connection 23a is at 1, (2) 27a is at 0, (3) 23b is at 0 and (4) 27b is at 1.

Assume now that input voltage 19 has changed to the binary 0 state while conditions just described prevail. As clock 21 turns "ON" 20a, 23a is set to the 0 state. Output 34 is coupled to 27b which is still in the binary 1 state. On the complementary phase of the clock 32, input 19 and output 34 are terminated. The 0 at 23a is inverted by 30a, 28a and forces 23b to 1, which is inverted by 30b, 28b to a 0. Thus it is seen that the input polarity is duplicated at the output after one full clock cycle. A much longer digital delay can now be realized by cascading numerous like stages.

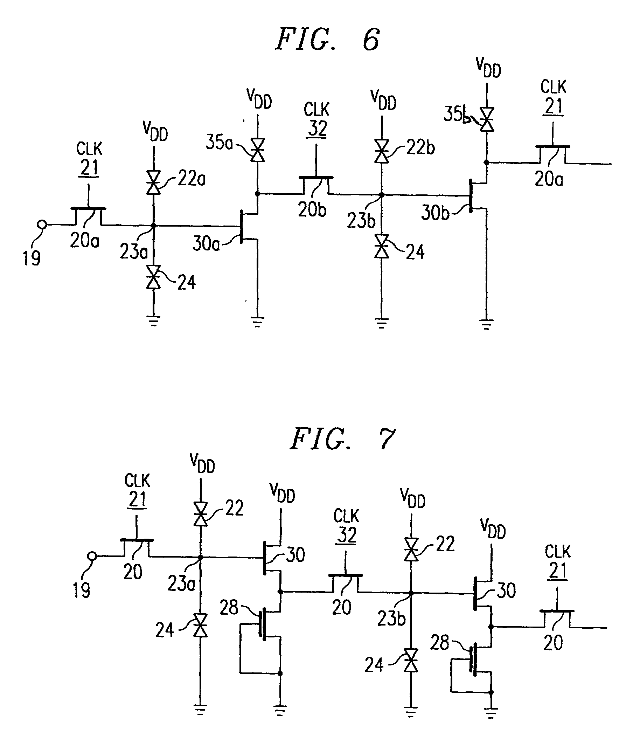

The functionality of the embodiment of the invention as shown in FIG.6 is the same in the digital sense but is capable of much higher speeds. RTD 35a replaces the depletion load transistor 28a of FIG.5. As mentioned previously, the I-V characteristics of RTD's may be tailored to the application. In this case RTD 35a must supply enough voltage when amplifier 30a is in the low current state to force 23b to the binary 1 state when switch 20b is closed. In the reverse case, 30a will be in the high current state and force 23b to the binary 0 state. The design goals for 35a and 35b are (1) low bias current and (2) adequate logic swing with good noise margin. From the device point of view this means that the peak voltage of 35a and 35b should be approximately half of the swing of 23a and 23b respectively. The step-by-step binary sequence and polarities are the same as FIG 5.

The output stages of a shift register are often called on to drive transmission lines to following stages where they may incur severe capacitive loading. In this regard, FIG.7 shows a circuit, which may be incorporated into the embodiment of the invention. Here the buffer stage between the static latching pairs of RTDs is a noninverting source follower consisting of enhancement mode FET 30 and a source depletion load device 28. The complementary clocking is the same as the previous circuits but in this case there is no inversion between the two shift register stages. In this case when 23a is forced to a binary state by clock phase 21, 23b is forced to the same binary state during the complementary phase 32. All the other components function as previously described.

While the principles of the present invention are disclosed herein, it will be recognized that various departures may be undertaken in the practice of this invention. For example, a specially designed RTD may also be used as a source follower load as an obvious combination of the functions described in FIG.5 and FIG.6.

## Claims

1. A storage cell for use in a static shift register, said storage cell comprising:
a static latch;
means for setting the binary state of said static latch in accordance with the level of an input signal; and
means coupled to said static latch for providing isolation from and gain to a subsequent static latch, **characterised in that**
the static latch is formed of a pair of series-connected negative resistance devices coupled between first and second potentials and
said means for providing isolation and gain includes a buffer amplifier (26), said buffer amplifier (26) comprising an enhancement FET (30) having a control region thereof coupled to a junction (23) between said pair of negative resistance devices and having its current guiding path coupled in series with a third negative resistance device (35).

2. The storage cell in accordance with Claim 1, wherein said negative resistance devices comprise resonant tunneling diodes (22,24).

3. The storage cell in accordance with Claim 1 or Claim 2, wherein said means for setting the binary state of said static latch comprises a clocked switching FET (20).

4. The storage cell in accordance with any of Claims 1 to 3, wherein said storage cell is arranged for use in a high speed static shift register.

5. A static shift register comprising:
a plurality of storage cells coupled in cascade configuration, each storage cell comprising:
a static latch;
means for setting the binary state of said static latch in accordance with the output level of the static latch of the preceding cell of said cascade; and
means coupled to said static latch for providing isolation from and gain to the static latch of the subsequent cell of said cascade, **characterized in that**
the static latch of each cell is formed of a pair of series-connected negative resistance devices coupled between first and second potentials, and
said means for providing isolation and gain includes a buffer amplifier, said buffer amplifier comprising an enhancement FET (30a, 30b) having a control region thereof coupled to the junction (23a, 23b) between said pair of negative resistance devices and having its current guiding path coupled with a third negative resistance device (35a, 35b).

6. The static shift register in accordance with Claim 5, wherein said negative resistance devices comprise resonant tunneling diodes (22a, 22b, 24a, 24b).

7. The static shift register in accordance with Claim 5 or Claim 6, wherein said register comprises a storage cell comprising a buffer amplifier including a noninverting source follower comprising an enhancement FET (30) and a source depletion load FET (28).

8. The static shift register in accordance with any of Claims 5 to 7, wherein said means for setting the binary state of said static latch comprises a clocked switching FET (20a, 20b).

9. The static shift register in accordance with Claim 8 wherein alternative ones (20a) of said switching FETs (20a, 20b) are clocked on one phase of a clock signal and the remaining ones (20b) of said switching FETs are clocked on a second phase of said clock signal.

10. The static shift register in accordance with any of Claims 5 to 9, wherein said static shift register is a high speed digital static shift register.

## Patentansprüche

1. Speicherzelle für die Verwendung in einem statischen Schieberegister, wobei die Speicherzelle umfaßt:
einen statischen Signalspeicher;
Mittel zum Setzen des binären Zustandes des statischen Signalspeichers in Übereinstimmung mit dem Pegel eines Eingangssignals; und
Mittel, die mit dem statischen Signalspeicher gekoppelt sind, um eine Isolation gegenüber einem nachfolgenden statischen Signalspeicher und eine Verstärkung für diesen zu schaffen, **dadurch gekennzeichnet, daß**
der statische Signalspeicher aus einem Paar von in Reihe geschalteten Vorrichtungen mit negativem Widerstand, die zwischen erste und zweite Potentiale geschaltet sind, gebildet ist und
die Mittel, die eine Isolation und eine Verstärkung schaffen, einen Pufferverstärker (26) enthalten, der einen Anreicherungs-FET (30) umfaßt, der einen Steuerbereich besitzt, der mit einem Übergang (23) zwischen dem Paar von Vorrichtungen mit negativem Widerstand verbunden ist und dessen Stromleitungspfad mit einer dritten Vorrichtung (35) mit negativem Widerstand gekoppelt ist.

2. Speicherzelle nach Anspruch 1, bei der die Vorrichtungen mit negativem Widerstand Resonanztunneldioden (22, 24) umfassen.

3. Speicherzelle nach Anspruch 1 oder Anspruch 2, bei der die Mittel zum Setzen des binären Zustandes des statischen Signalspeichers einen getakteten Schalt-FET (20) umfassen.

4. Speicherzelle nach einem der Ansprüche 1 bis 3, wobei die Speicherzelle für die Verwendung in einem statischen Hochgeschwindigkeits-Schieberegister ausgelegt ist.

5. Statisches Schieberegister, mit:
mehreren Speicherzellen, die in einer Kaskadenkonfiguration gekoppelt sind und wovon jede umfaßt:
einen statischen Signalspeicher;
Mittel zum Setzen des binären Zustandes des statischen Signalspeichers in Übereinstimmung mit dem Ausgangspegel des statischen Signalspeichers der der Kaskade vorhergehenden Zelle; und
Mittel, die mit dem statischen Signalspeicher gekoppelt sind, um eine Isolation gegenüber dem statischen Signalspeicher der nachfolgenden Zelle der Kaskade und eine Verstärkung für diesen zu schaffen, **dadurch gekennzeichnet, daß**
der statische Signalspeicher jeder Zelle aus einem Paar von in Reihe geschalteten Vorrichtungen mit negativem Widerstand, die zwischen erste und zweite Potentiale geschaltet sind, gebildet ist und
die Mittel für die Schaffung einer Isolation und einer Verstärkung einen Pufferverstärker enthalten, der einen Anreicherungs-FET (30a, 30b) umfaßt, der einen Steuerbereich besitzt, der mit dem Übergang (23a, 23b) zwischen dem Paar von Vorrichtungen mit negativem Widerstand verbunden ist und dessen Stromleitungspfad mit einer dritten Vorrichtung (35a, 35b) mit negativem Widerstand gekoppelt ist.

6. Statisches Schieberegister nach Anspruch 5, bei dem die Vorrichtungen mit negativem Widerstand Resonanztunneldioden (22a, 22b, 24a, 24b) umfassen.

7. Statisches Schieberegister nach Anspruch 5 oder Anspruch 6, wobei das Register eine Speicherzelle umfaßt, die ihrerseits einen Pufferverstärker umfaßt, der einen nicht invertierenden Source-Folger enthält, der einen Anreicherungs-FET und einen Sourceverarmungs-Last-FET (28) umfaßt.

8. Statisches Schieberegister nach einem der Ansprüche 5 bis 7, bei dem die Mittel zum Setzen des binären Zustandes des statischen Signalspeichers einen getakteten Schalt-FET (20a, 20b) umfassen.

9. Statisches Schieberegister nach Anspruch 8, bei dem abwechselnde (20a) der Schalt-FETs (20a, 20b) in einer Phase eines Taktsignals getaktet werden und die verbleibenden (20b) der Schalt-FETs in einer zweiten Phase des Taktsignals getaktet werden.

10. Statisches Schieberegister nach einem der Ansprüche 5 bis 9, wobei das statische Schieberegister ein digitales, statisches Hochgeschwindigkeits-Schieberegister ist.

## Revendications

1. Cellule de mémorisation à utiliser dan un registre à décalage statique, ladite cellule de mémorisation comprenant :
un circuit à verrouillage statique ;
un moyen pour déterminer l'état binaire dudit circuit à verrouillage statique conformément au niveau d'un signal d'entrée ; et
un moyen couplé audit circuit à verrouillage statique pour fournir un isolement et un gain à un circuit à verrouillage statique suivant, **caractérisée en ce que**
le circuit à verrouillage statique est constitué d'une paire d'éléments à résistance négative connectés en série couplés entre des premier et deuxième potentiels et
ledit moyen pour fournir isolement et gain inclut un amplificateur séparateur (26), ledit amplificateur séparateur (26) comprenant un transistor à effet de champ à enrichissement (30) ayant une région de commande de celui-ci couplée à une jonction (23) entre ladite paire d'éléments à résistance négative et ayant son chemin de guidage de courant couplé en série avec un troisième élément à résistance négative (35).

2. Cellule de mémorisation selon la revendication 1, dans laquelle lesdits éléments à résistance négative comprennent des diodes à effet tunnel résonnantes (22, 24).

3. Cellule de mémorisation selon la revendication 1 ou la revendication 2, dans laquelle ledit moyen pour déterminer l'état binaire dudit circuit à verrouillage statique comprend un transistor à effet de champ de commutation cadencé (20).

4. Cellule de mémorisation selon l'une quelconque des revendications 1 à 3, dans laquelle ladite cellule de mémorisation est adaptée pour être utilisée dans un registre à décalage statique rapide.

5. Registre à décalage statique comprenant :
une pluralité de cellules de mémorisation couplées en configuration cascade, chaque cellule de mémorisation comprenant :
un circuit à verrouillage statique ;
un moyen pour déterminer l'état binaire dudit circuit à verrouillage conformément au niveau de sortie du circuit à verrouillage de la cellule précédente de ladite cascade ; et
un moyen couplé audit circuit à verrouillage statique pour fournir un isolement et un gain au circuit à verrouillage de la cellule suivante de ladite cascade, **caractérisé en ce que**
le circuit à verrouillage de chaque cellule est constitué d'une paire d'éléments à résistance négative connectés en série couplés entre des premier et deuxième potentiels, et
ledit moyen pour fournir isolement et gain inclut un amplificateur séparateur, ledit amplificateur séparateur comprenant un transistor à effet de champ à enrichissement (30a, 30b) ayant une région de commande de celui-ci couplée à la jonction (23a, 23b) entre ladite paire d'éléments à résistance négative et ayant son chemin de guidage de courant couplé avec un troisième élément à résistance négative (35a, 35b).

6. Registre à décalage statique selon la revendication 5, dans lequel lesdits éléments à résistance négative comprennent des diodes à effet tunnel résonnantes (22a, 22b, 24a, 24b).

7. Registre à décalage statique selon la revendication 5 ou la revendication 6, dans lequel ledit registre comprend une cellule de mémorisation comprenant un amplificateur séparateur incluant un dispositif suiveur de source non inverseur comprenant un transistor à effet de champ à enrichissement (30) et un transistor à effet de champ de charge à appauvrissement de source (28).

8. Registre à décalage statique selon l'une quelconque des revendications 5 à 7, dans lequel ledit moyen pour déterminer l'état binaire dudit circuit à verrouillage comprend un transistor à effet de champ de commutation cadencé (20a, 20b).

9. Registre à décalage statique selon la revendication 8, dans lequel les premiers (20a) desdits transistors à effet de champ de commutation (20a, 20b) sont cadencés sur une première phase d'un signal d'horloge et ceux restants (20b) desdits transistors à effet de champ de commutation sont cadencés sur une deuxième phase dudit signal d'horloge.

10. Registre à décalage statique selon l'une quelconque des revendications 5 à 9, dans lequel ledit registre à décalage statique est un registre à décalage statique numérique rapide.
